# EUROPÄISCHE PATENTSCHRIFT

(11) **EP 2 746 424 B1**
(45) Veröffentlichungstag und Bekanntmachung des Hinweises auf die Patenterteilung: **17.10.2018**
(21) Anmeldenummer: 13195127.9
(22) Anmeldetag: 29.11.2013
(51) Int. Cl.: C23C 14/34, C23C 14/32, H01J 37/34, C23C 14/24, H01J 37/32

(54) **Verdampfungsquelle**
Evaporation source
Source d'évaporation

(30) Priorität: 21.12.2012 EP 12198948
(43) Veröffentlichungstag der Anmeldung: 25.06.2014
(73) Patentinhaber: Oerlikon Surface Solutions AG, Pfäffikon, 8808 Pfäffikon SZ (CH)
(72) Erfinder: Vetter, Jörg Dr., 51469 Bergisch Gladbach (DE); Dr. Stefan Esser,, 50072 Aachen (DE); Müller, Jürgen Dr., 57462 Olpe (DE); Erkens, Georg Dr., 52070 Aachen (DE)
(74) Vertreter: Intellectual Property Services GmbH

(56) Entgegenhaltungen:
- EP-A1- 2 484 798
- WO-A1-2007/050305
- DE-A1-102011 075 543
- US-A- 5 262 032

## Beschreibung

Die Erfindung betrifft eine Verdampfungsquelle, insbesondere zur Verwendung in einem Sputterverfahren oder einem Vakuumverdampfungsverfahren, bevorzugt kathodisches Vakuumverdampfungsverfahren gemäss des unabhängigen Anspruchs 1.
Zum Aufbringen von Schichten oder Schichtsystemen auf die unterschiedlichsten Substrate sind aus dem Stand der Technik eine ganze Reihe verschiedener chemischer, mechanischer und physikalischer Techniken bekannt, die je nach Anforderung und Einsatzgebiet ihre Berechtigung haben und entsprechende Vor- und Nachteile aufweisen.
Zum Aufbringen verhältnismässig dünner Schichten sind insbesondere Verfahren geläufig, bei welchen die Oberfläche eines Targets in einem Lichtbogen in die Dampfform überführt wird oder aber aus einer Oberfläche eines Targets Atome mittels ionisierter Teilchen in die Dampfform überführt werden, wobei sich der so gebildete Dampf dann als Beschichtung auf einem Substrat niederschlagen kann.
In einer üblichen Ausführungsform der Kathodenzerstäubung wird in einem Sputterprozess das Target an eine negative ungepulste Gleichstromspannungsquelle, oder z.B. an eine unipolare oder bipolare gepulste Quelle angeschlossen, oder im HiPIMS Mode betrieben, oder an eine hochfrequente Stromquelle angeschlossen. Die Entladung wird in der Regel durch Magnetsysteme verstärkt. Man spricht dann von Magnetronzerstäubung. Das Substrat ist das zu beschichtende Material und es befindet sich zum Beispiel dem Target gegenüber. Das Substrat kann geerdet, schwimmend, vorgespannt, erhitzt, gekühlt sein oder einer Kombination hiervon unterworfen werden. In die Prozesskammer, die unter anderem die Prozesselektroden und das Substrat enthält, wird ein Prozessgas eingeführt, um eine Gasatmosphäre zu schaffen, in welchem eine Glimmentladung ausgelöst und aufrechterhalten werden kann. Die Gasdrücke reichen je nach Anwendung von wenigen Zehntel eines Pascals bis zu mehreren Pascal. Ein häufig verwendetes Zerstäubergas ist Argon.

Wenn die Glimmentladung ausgelöst wird, treffen positive Ionen auf die Oberfläche des Targets und lösen hauptsächlich neutrale Targetatome durch Stoßkraftübertragung heraus. Diese kondensieren auf dem Substrat, um dünne Filme zu bilden. Es gibt zusätzlich noch andere Partikel und Strahlungen, die durch das Target erzeugt werden und alle filmbildende Eigenschaften haben (Sekundärelektronen und Ionen, desorbierte Gase, und Photonen). Die Elektronen und negativen Ionen werden gegen die Substratplattform beschleunigt und bombardieren diese und den wachsenden Film. In einigen Fällen wird ein zum Beispiel negatives Vorspannungspotential an den Substrathalter gelegt, so daß der wachsende Film dem Beschuss mit positiven Ionen ausgesetzt ist. Dieser Prozess ist auch als Vorspannungszerstäubung oder Ionenplattierung bekannt.

In bestimmten Fällen werden nicht nur Argon, sondern andere Gase oder Gasmischungen verwendet. Das schließt gewöhnlich einige Arten von Reaktionszerstäuberprozessen ein, in welchen eine Zusammensetzung durch Zerstäuben eines Metalltargets (z. B.Ti) in einem zumindest zum Teil reaktiven Reaktionsgas synthetisiert wird, um eine Zusammensetzung aus dem Metall und den Reaktionsgasarten (z.B. Titanoxide) zu bilden. Der Zerstäubungsertrag wird definiert als Zahl der aus der Targetoberfläche ausgestoßenen Atome pro einfallendem Ion. Es ist ein wesentlicher Parameter zur Charakterisierung des Zerstäuberprozesses.

Schätzungsweise ein Prozent der auf eine Targetoberfläche einfallenden Energie führt gewöhnlich zum Ausstoßen zerstäubter Partikel, 75 % der einfallender Energie führen zur Erwärmung des Target und der Rest wird zum Beispiel durch sekundäre Elektronen zerstreut, die das Substrat bombardieren und erhitzen können. Ein als Magnetron-Zerstäubung bekannter verbesserter Prozeß verwendet magnetische Felder zur Führung der Elektronen weg von der Substratoberfläche, wodurch die Wärmeeinwirkung reduziert wird.

Für ein gegebenes Targetmaterial werden die Auftragsrate und die Gleichmäßigkeit unter anderem durch die Systemgeometrie, die Targetspannung, das Zerstäubergas, den Gasdruck und die an die Prozesselektroden angelegte elektrische Leistung beeinflußt.

Ein verwandtes physikalisches Beschichtungsverfahren ist die bekannte Lichtbogenverdampfung in ihren vielfältigen Ausgestaltungen.

Bei der Lichtbogenverdampfung wird das Targetmaterial durch die Wirkung von Vakuumlichtbögen verdampft. Das Targetquellenmaterial ist die Kathode in dem Lichtbogenkreis. Die Grundkomponenten eines bekannten Lichtbogenverdampfungssystems bestehen aus einer Vakuumkammer, einer Kathode und einem Lichtbogenstromanschluß, Teilen zum Zünden eines Lichtbogens auf der Kathodenoberfläche, einer Anode, einem Substrat und aus einem Stromanschluß für eine Substratvorspannung. Die Lichtbögen werden durch Spannungen im Bereich von zum Beispiel 15-50 Volt gehalten, abhängig von dem Targetkathodenmaterial, das verwendet wird. Typische Lichtbogenströme liegen im Bereich von 30-400 A. Die Lichtbogenzündung erfolgt durch die üblichen dem Fachmann bekannten Zündverfahren.

Die Verdampfung des Targetmaterials aus der Kathode, die das Target bildet, ergibt sich als Resultat eines kathodischen Lichtbogenpunktes, der sich im einfachsten Fall regellos auf der Kathodenfläche mit Geschwindigkeiten von üblicherweise 10 m/s bewegt. Die Lichtbogenpunktbewegung kann dabei aber auch mit Hilfe geeigneter Einschlußabgrenzungen und / oder magnetischer Felder gesteuert werden. Das Target-Kathodenmaterial kann zum Beispiel ein Metall oder eine Metalllegierung sein.

Der Lichtbogenbeschichtungsprozess ist erheblich verschieden von anderen physikalischen Dampfbeschichtungsprozessen. Der Kern der bekannten Lichtbogenprozesse ist der Lichtbogenpunkt, der ein Materialplasma erzeugt. Ein hoher Prozentsatz, z.B. 30 % - 100 % des von der Kathodenfläche verdampften Materials ist in der Regel ionisiert, wobei die Ionen in verschiedenen Ladungszuständen im Plasma, beispielsweise als Ti+, Ti2+, Ti3+ usw. existieren können. Die kinetische Energie der Ionen kann sich dabei im Bereich von z.B. 10 - 100 eV bewegen.

Diese Merkmale führen zu Beschichtungen, die von höchster Qualität sein können, und verglichen mit jenen Beschichtungen, die mit von anderen physikalischen Dampfbeschichtungsprozessen aufgetragen werden, bestimmte Vorteile aufweisen können.

Die mittels Lichtbogenverdampfung aufgetragene Schichten zeigen meist über einen breiten Bereich der Beschichtungsbedingungen eine hohe Qualität. So lassen sich z. B. stöchiometrische Verbundfilme mit höchster Adhäsion und hoher Dichte herstellen, die über einen weiten Bereich des Reaktionsgasdruckes hohe Beschichtungsbeträge für Metalle, Legierungen und Zusammensetzungen mit exzellenter Beschichtungsgleichmäßigkeit liefern. Neben anderen ist ein weiterer Vorteil auch die verhältnismässig niedrigen Substrattemperaturen und die relativ einfache Herstellung von Verbundfilmen.

Der kathodische Lichtbogen führt zu einer Plasmaentladung innerhalb des von der Kathodenfläche freigesetzten Materialdampfes. Der Lichtbogenpunkt ist normalerweise einige Mikrometer groß und hat Stromdichten von 10 Ampere pro Quadratmikrometer. Diese hohe Stromdichte verursacht eine blitzartige Verdampfung des Ausgangsmaterials. Der erzeugte Dampf besteht aus Elektronen, Ionen, neutralen Dampfatomen und Mikrotröpfchen. Die Elektronen werden gegen die Wolken positiver Ionen beschleunigt. Die Emissionen des Kathodenlichtpunkts sind über einen breiten Bereich des Lichtbogenstromes relativ konstant, wenn der Kathodenpunkt in mehrere Punkte aufgeteilt wird. Der Durchschnittsstrom pro Punkt hängt von der Natur des Kathodenmaterials ab.

Dabei spielt oft auch die Geometrie der Verdampfungsquelle eine wesentliche Rolle. So ist es bekannt sowohl rechteckige als auch zylinderförmige Verdampfungsquellen zu verwenden. Die Auswahl der Geometrie der Verdampfungsquelle kann dabei von einer Vielzahl von Parametern und Randbedingungen der speziellen Beschichtungsanwendung abhängen.

Ein Nachteil der Beschichtungsanlage und des Verfahrens gemäss WO 90/02216 besteht unter anderem darin, dass insbesondere eine gleichbleibende Qualität der Beschichtungen nicht gewährleistet ist. So ändert sich mit zunehmendem Verbrauch der Kathoden die Qualität der aufgebrachten Schichten, wenn nicht die Verfahrensparameter aufwendig nachgeführt werden. Das liegt unter anderem bekanntermassen daran, dass sich die rechteckigen Kathoden ungleichmässig verbrauchen, so dass bei gleichen Verfahrensparametern mit zunehmender Erosion der Kathoden die Qualität des Beschichtungsdampfes zunehmend schlechter wird, weil sich z.B. in zunehmendem Masse störende Tröpfchen beim Lichtbogenverdampfen bilden, was sich negativ auf die Schichten auswirkt. Um diese negativen Effekte in Grenzen zu halten, müssen die Kathoden frühzeitig ausgetauscht werden, was entsprechend teuer und aufwändig ist.

Ein weiterer Nachteil neben der ungleichmässigen Erosion der Kathoden ist, dass eine Steuerung des Lichtbogens auf der Kathode, sofern überhaupt möglich, sehr schwierig und aufwendig ist.

Daher ist es häufig vorteilhafter eine zylindrische Kathode zu verwenden, was bekanntermassen den Vorteil hat, dass die zylindrische Kathode um ihre Zylinderachse drehbar ist und so der Verbrauch des Tragetmaterials besser handhabbar ist. Diese Problematik wurde von der Anmelderin früher bereits eingehend in der EP 2 159 821 diskutiert. Durch Verwendung von Verdampfungsquellen gemäss EP 2 159 821 ändert sich mit zunehmendem Verbrauch der Kathoden die Qualität der aufgebrachten Schichten nicht, und die Verfahrensparameter müssen nicht aufwendig nachgeführt werden. Das liegt unter anderem daran, dass sich die zylindrischen Kathoden gleichmässig verbrauchen, so dass bei gleichen Verfahrensparametern mit zunehmender Erosion der Kathoden die Qualität des Beschichtungsdampfes gleich bleibt und nicht deshalb schlechter wird, weil sich z.B. in zunehmendem Masse störende Tröpfchen beim Lichtbogenverdampfen bilden, was sich negativ auf die Schichten auswirkt. Da bei Verdampfungsquellen gemäss EP 2 159 821 diese negativen Effekte praktisch nicht mehr auftreten, müssen die Kathoden nicht mehr frühzeitig ausgetauscht werden, was zu entsprechenden bedeutenden Kosteneinsparungen führt.
Ein bisher nicht wirklich befriedigend gelöstes Problem zylindrischer Kathoden ist jedoch deren Kühlung. Wie eingangs erwähnt, wird ein grosser Anteil der in die Verdampfungsquellen eingebrachten Energie in Wärme umgewandelt, die natürlich von der Verdampfungsquelle wieder weggeführt werden muss. Dazu sind aus dem Stand der Technik eine Reihe von Vorschlägen bekannt.
Die DE 10 2011 075 543 A1 beschreibt eine Anordnung zur Kühlung eines längserstreckten Magnetron, wobei das Magnetron ein Target eines zu zerstäubenden Materiales, ein Magnetsystem, und ein Kühlsystem mit einer von einem Kühlmedium in Längserstreckung durchflossenen Kühlmittelführung umfasst. Die Kühlmittelführung umfasst eine Zuleitung von einem Kühlmitteleinlass an einem ersten Ende des Magnetron zu einem zweiten Ende des Magnetron. Zuleitung und Rückleitung sind mit einer umlenkenden Verbindung am zweiten Ende verbunden und das Kühlmittel strömt im Gegenstromprinzip.
Die US 5 262 032 A offenbart eine Magnetronkatode mit rotierendem Target und einer Targetkühlung, die durch ein strömendes Kühlmedium erfolgt. Die Kühlung wird dabei auf den oder die Bereiche des rotierenden Targets konzentriert, der bzw. die der Hitzeentwicklung des Plasmas ausgesetzt sind, wobei die Magnete des Magnetaggregats mindestens einen Kühlkanal bilden.
Die DD 217 964 A3 beschreibt beispielweise eine zylindrische Verdampfungsquelle, bei welche die Kühlung im wesentlichen in der Nähe der Zylinderachse der Verdampfungsquelle geführt ist. Eine ähnliche Lösung zeigt die EP 1 173 629 B1. Ein wesentlicher Nachteil solcher Lösungen liegt darin, dass die die Kühlung im Inneren der Verdampfungsquelle einen bedeutenden Raum einnimmt, der dann für weitere notwendige Einbauten fehlt, wie beispielweise für Magnetsysteme die der Fachmann oft vorteilhaft im Inneren der Verdampfungsquelle unterbringen möchte. Ausserdem hat sich gezeigt, dass das Abführen der Wärme bei solchen Kühlsystemen häufig nicht genügend effizient ist, die Aufbauten kompliziert und, damit wartungsanfällig sind, was alles in allem natürlich auch die Kosten treibt.
Aufgabe der Erfindung ist es daher, eine verbesserte Verdampfungsquelle, insbesondere zur Verwendung in einem Sputterverfahren oder einem Vakuumbogenverdampfungsverfahren, im Speizellen kathodisches Vakuumbogenverdampfungsverfahren vorzuschlagen, bei der die aus dem Stand der Technik bekannten Probleme mit der Kühlung nicht mehr auftreten. Die diese Aufgabe lösenden Gegenstände der Erfindung sind durch die Merkmale des unabhängigen Anspruch 1 gekennzeichnet.
Die abhängigen Ansprüche beziehen sich auf besonders vorteilhafte Ausführungsformen der Erfindung.

Durch die vorliegende Erfindung ist somit eine ausserordentlich effiziente Kühlung der zylindrischen Verdampfungsquelle gewährleistet, weil durch die Anordnung des Kühlraums angrenzend an den äusseren Trägerkörper die in die Verdampfungsquelle eingebrachte Wärme praktisch unmittelbar am Ort ihres Eintrags in die Verdampfungsquelle von dem im Kühlraum zirkulierenden Kühlfluid, das bevorzugt Wasser ist, absorbiert und effizient abtransportiert wird.
Damit sind nicht nur das Innere der Verdampfungsquelle und eventuell darin untergebrachte Komponenten, wie ein Magnetsystem, elektrische Leitungen, oder elektronische Einrichtungen usw. effizient gegen übermässigen Wärmeeintrag und exzessive Temperaturen geschützt. Auch beansprucht die Kühlung im Inneren im Wesentlichen keinen bzw. nur sehr wenig Raum, d.h., bei einer erfindungsgemässen Verdampfungsquelle steht in deren Inneren ein beträchtlicher freier Raum zur Unterbringung von notwendigen Komponenten wie einem Magnetsystem, einem Trägersystem zur Justierung des Magnetsystems oder anderen elektrischen, elektronischen oder mechanischen Einrichtungen zur Verfügung. Durch das Vermeiden des Kontaktes der vorgenannten Komponenten (z.B. Magnete und Joche) mit dem Kühlfluid erfolgt kein korrosiver Angriff, so dass die Komponenten nicht aufwändig gegen Korrosion geschützt werden müssen und dadurch eine deutlich verlängerte Lebensdauer haben.
Bei einem bevorzugten Ausführungsbeispiel einer erfindungsgemässen Verdampfungsquelle ist der äussere Trägerkörper ein zylindrischer Targetträger und / oder der innere Grundkörper ist ein zylindrischer Kühlgrundkörper. Nach Anspruch 1 ist der äussere Trägerkörper in Bezug auf eine Verdampferachse koaxial zum Grundkörper angeordnet, wobei bevorzugt und / oder der Trägerkörper und / oder der Grundkörper ist um die Verdampferachse rotierbar angeordnet, wobei der Trägerkörper ein monolithischer Trägerkörper sein kann, d.h. der Trägerkörper kann aus einem zu verdampfenden Targetmaterial hergestellt sein. Der äussere Trägerkörper selbst kann somit das Target im eigentlichen Sinne bilden. Dabei versteht es sich von selbst, dass der Trägerkörper auch ein nicht monolithischer Trägerkörper sein kann, bei dem das Targetmaterial auf den äusseren Trägerkörper in an sich bekannter Weise aufgebracht sein kann. Der innere Grundkörper und der äussere Trägerkörper kann dabei aus jedem geeigneten Material gefertigt sein, z.B. der innere Grundkörper aus Edelstahl und der äussere Trägerkörper aus Aluminium. Dabei kann insbesondere der innere Grundkörper in speziellen Fällen natürlich auch eine von der Zylinderform abweichende Form haben.

Nach Anspruch 1 umschliesst der Grundkörper einen von dem Kühlfluid freien Magnetsystemraum, wobei der Zuströmraum durch eine Trennwand vom Abströmraum getrennt ist. In vielen Ausführungsbeispielen fixiert dabei eine gemeinsame Fixierplatte den Tragkörper am Grundkörper, wobei die Fixierplatte besonders bevorzugt mit einem Fixierelement, insbesondere mit einer Schraube am Grundkörper fixiert ist. Zum Ausgleich einer unterschiedlichen Wärmeausdehnung von äusserem Trägerkörper und innerem Grundkörper kann besonders vorteilhaft ein Dehnungselement, insbesondere ein Dehnungselement in Form einer Spiralfeder oder einer anderen Feder vorgesehen werden, so dass es im Fall einer Temperaturänderung nicht zu thermisch bedingten mechanischen Spannungen zwischen den Komponenten der Verdampfungsquelle kommt, und insbesondere mechanische Spannungen Trägerkörper und Grundkörper vermieden werden.
Es versteht sich dabei von selbst, dass auch mehr als zwei, also auch eine Mehrzahl von Zuströmräumen und / oder Abströmräumen und / oder entsprechenden Überströmverbindungen zwischen den Zuströmräumen und den Abströmräumen vorgesehen sein können, und in speziellen Ausführungsbeispielen kann im Zuströmraum und / oder im Abströmraum und / oder in der Überströmverbindung zur Erzeugung einer Verwirbelung im Kühlfluid ein Verwirbelungselement vorgesehen sein. Auch kann der Einlass und / oder der Auslass einen Verwirbelungskörper zur Verwirbelung des Kühlfluids umfassen. Dabei kann der Einlass und / oder der Auslass ebenfalls je nach Erfordernissen geometrische Besonderheiten aufweisen, z.B. kann der Einlass und / oder der Auslass mäanderförmig, insbesondere mäanderförmig um den Tragkörper ausgebildet.

Alle diese Massnahmen dienen dabei in erster Linie dazu, die Kühleffizienz zu verbessern.

Es versteht sich, dass in der Praxis bei einer erfindungsgemässen Verdampfungsquelle notwendige, dem Fachmann an sich bekannte weitere Komponenten vorgesehen werden können. Insbesondere kann z.B. ein Magnetsystem im Magnetsystemraum angeordnet sein, wobei das Magnetsystem besonders bevorzugt derart an einem bewegbaren Trägersystem vorgesehen sein kann, dass eine Stärke und / oder eine Form eines Magnetfelds in einem vorgebaren Bereich nach einem vorgebbaren Schema einstellbar ist, was und wie es dem Fachmann aus dem Stand der Technik bekannt ist.

Die Erfindung wird im Folgenden an Hand der schematischen Zeichnung näher erläutert. Es zeigen:
- Fig. 1a: ein erstes einfaches Ausführungsbeispiel einer erfindungsgemässen Verdampfungsquelle;
- Fig. 1b: einen Schnitt entlang der Schnittlinie I-I gemäss Figur 1a;
- Fig. 2: ein zweites Ausführungsbeispiel mit Dehnungselement an der Fixierplatte;
- Fig. 3a: ein drittes Ausführungsbeispiel mit linearer Kühlmittelzuführung;
- Fig. 3b: ein Ausführungsbeispiel gemäss Fig. 3a mit ringförmiger Zuführung;

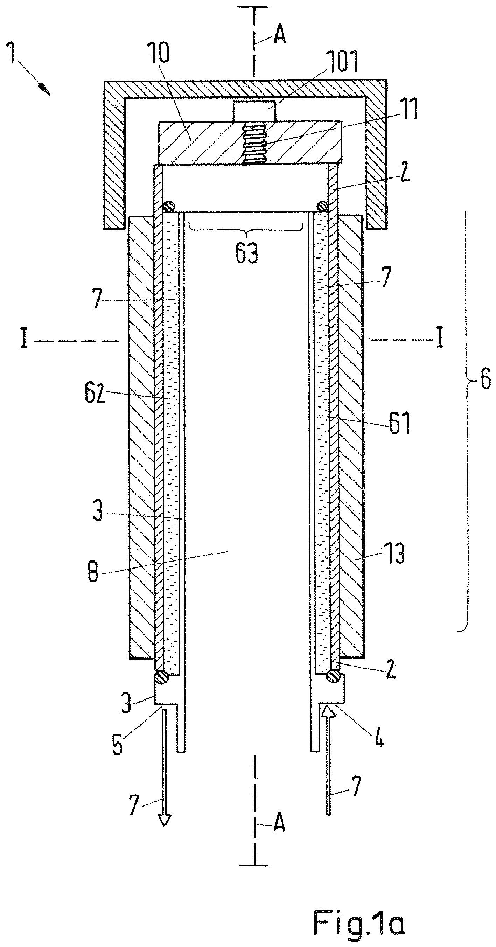

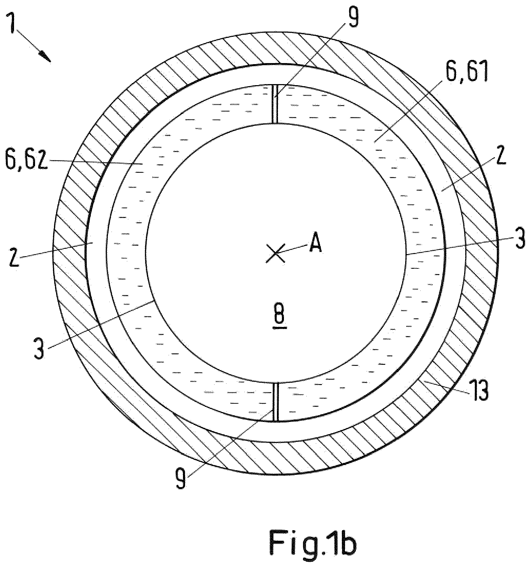

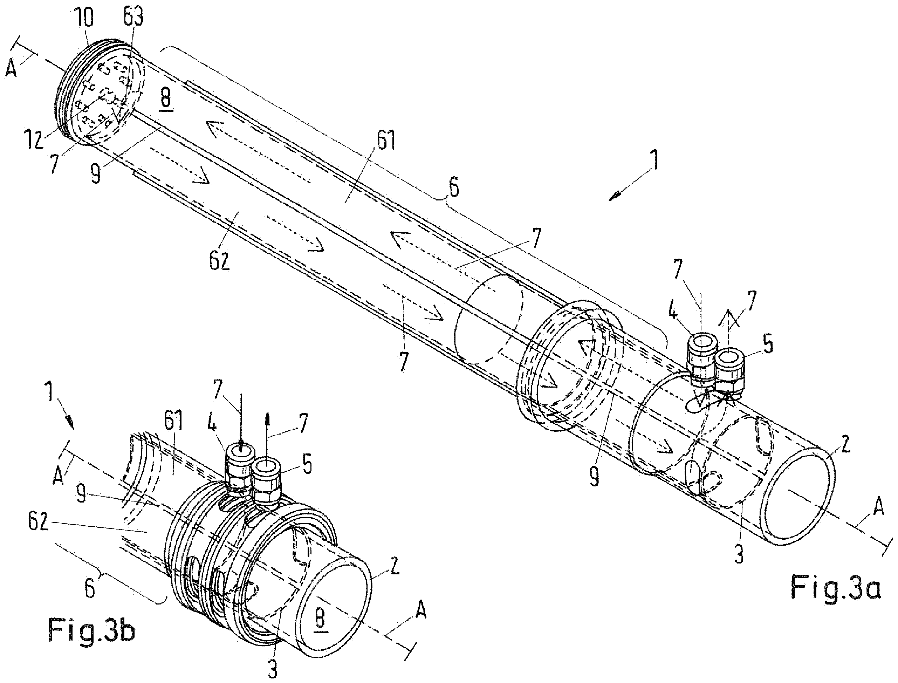

Fig. 1a zeigt in einer schematischen Darstellung ein einfaches Ausführungsbeispiel einer erfindungsgemässen Verdampfungsquelle, die im Folgenden gesamthaft mit dem Bezugszeichen 1 bezeichnet wird, wobei Fig. 1b zum besseren Verständnis einen Schnitt entlang der Schnittlinie I-I gemäss Fig. 1a zeigt.
Die erfindungsgemässe Verdampfungsquelle 1 gemäss Fig. 1a bzw. Fig. 1b ist insbesondere zur Verwendung in einem Sputterverfahren oder einem Vakuumbogenverdampfungsverfahren, bevorzugt zur Verwendung in einem kathodisches Vakuumbogenverdampfungsverfahren konzipiert. Die Verdampfungsquelle 1 umfasst einen in einem äusseren Trägerkörper 2 angeordneten inneren Grundkörper 3, der in Bezug auf den äusseren Trägerkörper 2 derart angeordnet ist, dass zwischen dem Grundkörper 3 und dem Trägerkörper 2 ein mit einem Einlass 4 und einem Auslass 5 strömungsverbundener Kühlraum 6 ausgebildet ist. Gemäss der vorliegenden Erfindung umfasst der Kühlraum 6 einen Zuströmraum 61 und einen Abströmraum 62, die jeweils einen zylindrischen Halbring-Körper bilden, wie man besonders gut auch der Fig. 1b entnehmen kann. Der Zuströmraum 61 ist dabei derart über eine Überströmverbindung 63 mit dem Abströmraum 62 strömungsverbunden, so dass ein Kühlfluid 7 vom Einlass 4 über den Zuströmraum 61, die Überströmverbindung 63, und den Abströmraum 62 zum Auslass 5 beförderbar ist. In Fig. 1a ist die Überströmverbindung 63 nicht direkt zu sehen, weil sie durch die Darstellung der Fixierplatte 10 verdeckt ist. Prinzipiell ist die Überströmverbindung 63 jedoch ähnlich ausgebildet, wie in dem später noch zu diskutierenden Ausführungsbeispiel der Fig. 3a.
Bei der Verdampfungsquelle 1 der Fig. 1a bzw. Fig. 1b ist der äussere Trägerkörper 2 ein zylindrischer Targetträger ist und der innere Grundkörper 3 ist ein zylindrischer Kühlgrundkörper, wobei der äussere Trägerkörper 2 in Bezug auf eine Verdampferachse A koaxial zum Grundkörper 3 angeordnet ist.

Der Grundkörper 3 umschliesst einen von dem Kühlfluid 7 freien Magnetsystemraum 8, in dem in der Praxis sehr häufig ein verstellbares Magnetsystem vorgesehen ist.

Der Zuströmraum 61 ist gemäss Fig. 1b durch eine Trennwand 9 vom Abströmraum 62 getrennt. Als Kühlfluid wird in der Praxis bevorzugt einfach Wasser verwendet. In speziellen Fällen kann als Kühlfluid aber auch ein anderes Fluid, wie z.B. ein Öl in Frage kommen, oder in speziellen Fällen eventuell sogar ein gasförmiges Fluid.

Am darstellungsgemäss oberen Ende der Verdampfungsquelle 1 ist der Trägerkörper 2 mit einer Fixierplatte 10 am Grundkörper 3 fixiert, wobei die Fixierplatte 10 mit einem Fixierelement 101, hier mit einer Schraube am Grundkörper 3 fixiert ist. Zum Ausgleich einer unterschiedlichen Wärmeausdehnung des äusserem Trägerkörper 2, der zum Beispiel aus Aluminium ist und auf dem das Targetmaterial 13 vorgesehen ist, und dem innerem Grundkörper 3, der zum Beispiel aus Edelstahl ist, ist ein Dehnungselement 11 in Form einer Spiralfeder vorgesehen, so dass mechanische Spannungen zwischen dem Trägerkörper 2 und dem Grundkörper 3 aufgrund unterschiedlicher thermischer Ausdehnungskoeffizienten vermieden werden können.

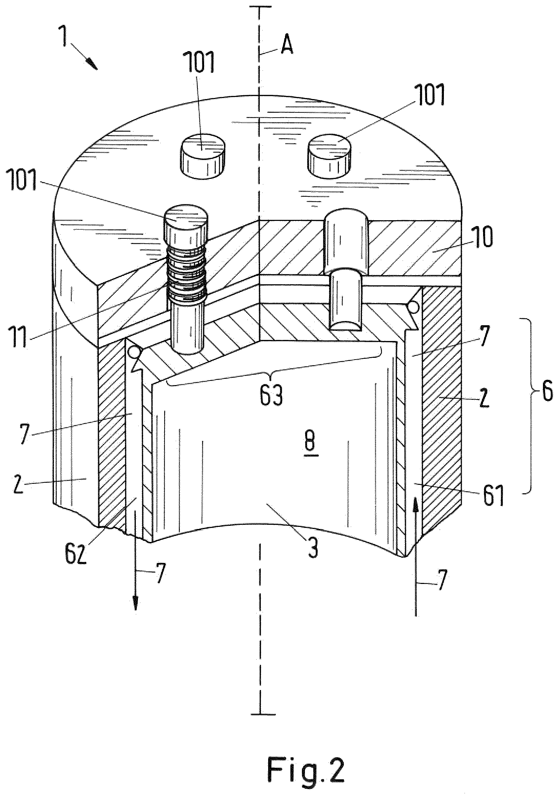

Fig. 2 zeigt ein zweites Ausführungsbeispiel einer erfindungsgemässen Verdampfungsquelle 1 mit Dehnungselement 11 an der Fixierplatte 10 in etwas genauerer Darstellung. Die Fixierplatte 10 wird mit insgesamt vier Fixierelementen 101, die hier gewöhnliche Schrauben, z.B. M6 Klasse 8.8 Schrauben sind, fixiert. An den Schrauben ist als Dehnungselement 11 jeweils eine Feder vorgesehen, die z.B. eine Vorspannung von ca. 120N und ca. 240N Nennspannung haben kann, beispielweise bei einem Federweg von ca 2mm, wie er bei einem Traget von ca. 5mm Länge gewöhnlich gewählt wird. Bei längeren oder kürzeren Targets kann der Federweg entsprechend angepasst werden. Dabei kann eine M6 Klasse 8.8 Schraube durchaus mit 9000N vorgespannt werden. In Fig. 2 sind dabei erst drei Schrauben montiert.

Fig. 3a zeigt ein drittes Ausführungsbeispiel mit linearer Kühlmittelzuführung, während Fig. 3b ein Ausführungsbeispiel gemäss Fig. 3a mit um den äusseren Tragkörper 2 geschlungener, ringförmiger Zuführung zeigt. Die Fig. 3a bzw. Fig. 3b sind dabei in sofern stark schematisch, als dass die bestimmte Bauteile transparent bzw. gar nicht dargestellt sind, so dass besonders gut die Anordnung der Trennwand 9 zu sehen ist, so dass man den dadurch bedingten Fluss des Kühlfluids 7 durch den Kühlraum 6 besser beobachten kann.

Es versteht sich von selbst, dass die zuvor erläuterten und in den Abbildungen schematisch dargestellten Ausführungsvarianten auch vorteilhaft miteinander zu weiteren Ausführungsbeispielen kombinierbar sind, um speziellen Anforderungen in der Praxis gerecht zu werden. Darüber hinaus sind selbstverständlich auch einfache, dem Fachmann naheliegende Weiterbildungen von der Erfindung erfasst.

## Patentansprüche

1. Verdampfungsquelle, insbesondere zur Verwendung in einem Sputterverfahren oder einem Vakuumbogenverdampfungsverfahren, bevorzugt kathodisches Vakuumbogenverdampfungsverfahren, welche Verdampfungsquelle einen in einem äusseren Trägerkörper (2) angeordneten inneren Grundkörper (3) umfasst, wobei der äussere Trägerkörper (2) in Bezug auf eine Verdampferachse (A) koaxial zum Grundkörper (3) angeordnet ist, und der Grundkörper (3) in Bezug auf den äusseren Trägerkörper (2) derart angeordnet ist, dass zwischen dem Grundkörper (3) und dem Trägerkörper (2) ein mit einem Einlass (4) und einem Auslass (5) strömungsverbundener Kühlraum (6) ausgebildet ist, wobei der Kühlraum (6) einen Zuströmraum (61) und einen Abströmraum (62) umfasst, und zur Kühlung der Verdampfungsquelle der Zuströmraum (61) derart über eine Überströmverbindung (63) mit dem Abströmraum (62) strömungsverbunden ist, dass ein Kühlfluid (7) vom Einlass (4) über den Zuströmraum (61), die Überströmverbindung (63), und den Abströmraum (62) zum Auslass (5) beförderbar ist, und der Grundkörper (3) einen von dem Kühlfluid (7) freien Magnetsystemraum (8) umschliesst, **dadurch gekennzeichnet, dass** der Zuströmraum (61) und der Abströmraum (62) einen gemeinsamen Ringkörper bilden, und im gemeinsamen Ringkörper der Zuströmraum (61) und der Abströmraum (62) jeweils einen zylindrischen Halbringkörper bilden, die in Umfangsrichtung durch eine Trennwand (9) voneinander getrennt sind.

2. Verdampfungsquelle nach Anspruch 1, wobei der äussere Trägerkörper (2) ein zylindrischer Targeträger ist und der innere Grundkörper (3) ein zylindrischer Kühlgrundkörper ist.

3. Verdampfungsquelle nach Anspruch 1 oder 2, wobei der Trägerkörper (2) und / oder der Grundkörper (3) um die Verdampferachse (A) rotierbar angeordnet ist.

4. Verdampfungsquelle nach einem der vorangehenden Ansprüche, wobei eine Fixierplatte (10) den Tragkörper (2) am Grundkörper (3) fixiert.

5. Verdampfungsquelle nach Anspruch4, wobei die Fixierplatte (10) mit einem Fixierelement (101), insbesondere Schraube, am Grundkörper (3) fixiert ist.

6. Verdampfungsquelle nach einem der vorangehenden Ansprüche, wobei zum Ausgleich einer unterschiedlichen Wärmeausdehnung von äusserem Trägerkörper (2) und innerem Grundkörper (3) ein Dehnungselement (11), insbesondere in Form einer Spiralfeder vorgesehen ist.

7. Verdampfungsquelle nach einem der vorangehenden Ansprüche, wobei auf Trägerkörper (2) aus einem zu verdampfenden Targetmaterial besteht.

8. Verdampfungsquelle nach einem der vorangehenden Ansprüche, wobei eine Mehrzahl von Zuströmräumen (61) und / oder Abströmräumen (62) und / oder Überströmverbindungen (63) vorgesehen ist.

9. Verdampfungsquelle nach einem der vorangehenden Ansprüche, wobei im Zuströmraum (61) und / oder im Abströmraum (62) und / oder in der Überströmverbindung (63) zur Erzeugung einer Verwirbelung im Kühlfluid (7) ein Verwirbelungselement vorgesehen ist.

10. Verdampfungsquelle nach einem der vorangehenden Ansprüche, wobei der Einlass (4) und / oder der Auslass (5) einen Verwirbelungskörper (12) zur Verwirbelung des Kühlfluids (7) umfasst.

11. Verdampfungsquelle nach einem der vorangehenden Ansprüche, wobei der Einlass (4) und / oder der Auslass (5) mäanderförmig, insbesondere mäanderförmig um den Tragkörper (2) ausgebildet ist.

12. Verdampfungsquelle nach einem der vorangehenden Ansprüche, wobei ein Magnetsystem im Magnetsystemraum (8) vorgesehen ist.

13. Verdampfungsquelle nach einem der vorangehenden Ansprüche, wobei das Magnetsystem derart an einem bewegbaren Trägersystem vorgesehen ist, dass eine Stärke und / oder eine Form eines Magnetfelds in einem vorgebaren Bereich nach einem vorgebbaren Schema einstellbar ist.

## Claims

1. An evaporation source, in particular for use in a sputtering process or a vacuum arc evaporation process, preferably a cathodic vacuum arc evaporation process, which evaporation source comprises an inner base body (3) arranged in an outer supporting body (2), wherein the outer supporting body (2) is arranged coaxially to the base body (3) with respect to an evaporator axis (A), and the base body (3) is arranged with respect to the outer supporting body (2) in such a way that between the basic body (3) and the supporting body (2) a cooling chamber (6) is formed, which is in flow connection with an inlet (4) and an outlet (5), wherein the cooling chamber (6) comprises an inflow chamber (61) and an outflow chamber (62), and for cooling the evaporation source, the inflow chamber (61) is in flow communication with the outflow chamber (62) via an overflow connection (63) in such a way that a cooling fluid (7) can be conveyed from the inlet (4) to the outlet (5) via the inflow chamber (61), the overflow connection (63) and the outflow chamber (62), and the base body (3) encloses a magnetic system space (8) free of the cooling fluid (7), **characterized in that** the inflow chamber (61) and the outflow chamber (62) form a common annular body, and the inflow chamber (61) and the outflow chamber (62) each form a cylindrical half annular body in the common annular body, which are separated from each other in the circumferential direction by a separating wall (9).

2. An evaporation source according to claim 1, wherein the outer supporting body (2) is a cylindrical target carrier and the inner base body (3) is a cylindrical cooling base body.

3. An evaporation source according to claim 1 or 2, wherein the supporting body (2) an / or the base body (3) is arranged so that it can rotate about the evaporator axis (A).

4. An evaporation source according to anyone of the preceding claims, wherein a fixing plate (10) fixes the supporting body (2) to the base body (3).

5. An evaporation source according to claim 4, wherein the fixing plate (10) is fixed to the base body (3) with a fixing element (101), in particular a screw.

6. An evaporation source according to anyone of the preceding claims, wherein an expansion element (11), in particular in the form of a spiral spring, is provided to compensate a different thermal expansion of the outer supporting body (2) and the inner base body (3).

7. An evaporation source according to anyone of the preceding claims, wherein the supporting body (2) consists of a target material to be vaporized.

8. An evaporation source according to anyone of the preceding claims, wherein a plurality of inflow chambers (61) and / or outflow chambers (62) and / or overflow connections (63) is provided.

9. An evaporation source according to anyone of the preceding claims, wherein a turbulence element for generating a turbulence in the cooling fluid (7) is provided in the inflow chamber (61) and / or in the outflow chamber (62) and / or in the overflow connection (63).

10. An evaporation source according to anyone of the preceding claims, wherein the inlet (4) and / or the outlet (5) comprises a turbulence body (12) for the turbulence of the cooling fluid (7).

11. An evaporation source according to anyone of the preceding claims, wherein the inlet (4) and / or the outlet (5) is meander-shaped, in particular meander-shaped around the supporting body (2).

12. An evaporation source according to anyone of the preceding claims, wherein a magnet system is provided in the magnet system chamber (8).

13. An evaporation source according to anyone of the preceding claims, wherein the magnet system is provided on a movable supporting system in such a way that a strength and / or a form of a magnetic field can be adjusted in a predeterminable range according to a predeterminable scheme.

## Revendications

1. Une source d'évaporation, en particulier pour l'utilisation dans un procédé de pulvérisation ou un procédé d'évaporation à arc sous vide, de préférence un procédé d'évaporation à arc sous vide cathodique, laquelle source d'évaporation comprend un corps de base interne (3) disposé dans un corps de support externe (2), dans laquelle le corps de support externe (2) est disposé coaxialement au corps de base (3) par rapport à un axe d'évaporateur (A), et le corps de base (3) est disposé par rapport au corps de support externe (2) de telle sorte qu'une chambre froide (6), qui est en communication fluide avec une entrée (4) et une sortie (5), est formée entre le corps de base (3) et le corps de support (2), ladite chambre froide (6) comprenant une chambre de flux entrant (61) et une chambre de flux sortant (62), et pour refroidir la source d'évaporation, la chambre de flux entrant (61) est en communication fluide avec la chambre de flux sortant (62) par l'intermédiaire d'un raccord de trop-plein (63) de telle sorte qu'un fluide de refroidissement (7) peut être convoyé de l'entrée (4) via la chambre de flux entrant (61), le raccord de trop-plein (63) et la chambre de flux sortant (62) vers la sortie (5), et le corps de base (3) enferme une chambre de système magnétique (8) libre du fluide de refroidissement (7), **caractérisé en ce que** la chambre de flux entrant (61) et la chambre de flux sortant (62) forment un corps annulaire commun, et la chambre de flux entrant (61) et la chambre de flux sortant (62) forment chacun un demi-anneau cylindrique dans le corps annulaire commun, lesdites demi-anneaux cylindriques sont séparés l'un de l'autre dans la direction circonférentielle par une paroi de séparation (9).

2. Une source d'évaporation selon la revendication 1, dans laquelle le corps de support externe (2) est un support de cible cylindrique et le corps de base interne (3) est un corps de base de refroidissement cylindrique.

3. Une source d'évaporation selon la revendication 1 ou 2, dans laquelle le corps de support (2) et / ou le corps de base (3) est disposé de manière rotative autour de l'axe d'évaporateur (A).

4. Une source d'évaporation selon l'une des revendications précédentes, dans laquelle une plaque de fixation (10) fixe le corps de support (2) au corps de base (3).

5. Une source d'évaporation selon la revendication 4, dans laquelle la plaque de fixation (10) est fixée au corps de base (3) avec un élément de fixation (101), en particulier une vis.

6. Une source d'évaporation selon l'une des revendications précédentes, dans laquelle un élément de dilatation (11), en particulier sous la forme d'un ressort en spirale, est prévu pour compenser une dilatation thermique différente du corps de support externe (2) et du corps de base interne (3).

7. Une source d'évaporation selon l'une des revendications précédentes, dans laquelle le corps de support (2) est constitué d'un matériau cible à vaporiser.

8. Une source d'évaporation selon l'une des revendications précédentes, dans laquelle une pluralité des chambres de flux entrant (61) et / ou des chambres de flux sortant (62) et / ou des raccords de trop-plein (63) est prévue.

9. Une source d'évaporation selon l'une des revendications précédentes, dans laquelle un élément de tourbillon est prévu dans la chambre de flux entrant (61) et / ou dans la chambre de flux sortant (62) et / ou dans le raccord de trop-plein (63) pour générer un tourbillon dans le fluide de refroidissement (7).

10. Une source d'évaporation selon l'une des revendications précédentes, dans laquelle l'entrée (4) et / ou la sortie (5) comprend un corps de tourbillon (12) pour tourbillonner le fluide de refroidissement (7).

11. Une source d'évaporation selon l'une des revendications précédentes, dans laquelle l'entrée (4) et / ou la sortie (5) est en forme de méandre, en particulier en forme de méandre autour du corps de support (2).

12. Une source d'évaporation selon l'une des revendications précédentes, dans laquelle un système magnétique est prévu dans la chambre du système magnétique (8).

13. Une source d'évaporation selon l'une des revendications précédentes, dans laquelle le système magnétique est prévu sur un système de support mobile de telle sorte qu'une intensité et / ou une forme de champ magnétique peut être réglée dans une plage prédéfinie selon un schéma prédéfinie.
